# EUROPÄISCHE PATENTSCHRIFT

(11) **EP 3 284 327 B1**
(45) Veröffentlichungstag und Bekanntmachung des Hinweises auf die Patenterteilung: **09.02.2022**
(21) Anmeldenummer: 16707702.3
(22) Anmeldetag: 26.02.2016
(51) Int. Cl.: H05K 5/00

(54) **ELEKTRONIKMODUL FÜR EIN GETRIEBESTEUERGERÄT**
ELECTRONICS MODULE FOR A TRANSMISSION CONTROLLER
MODULE ÉLECTRONIQUE POUR DISPOSITIF DE COMMANDE DE TRANSMISSION

(30) Priorität: 17.04.2015 DE 102015207048
(43) Veröffentlichungstag der Anmeldung: 21.02.2018
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2016/054170
(87) Internationale Veröffentlichungsnummer: WO 2016/165867

(56) Entgegenhaltungen:
- EP-A2- 1 239 710
- DE-A1-102008 014 457
- DE-C1- 19 712 842

## Beschreibung

### Gebiet der Erfindung

Die Erfindung betrifft allgemein Elektronikmodule. Insbesondere betrifft die Erfindung Elektronikmodule mit einem Sensorelement für ein Getriebesteuergerät eines Kraftfahrzeugs.

### Stand der Technik

Zur Steuerung von Getrieben, insbesondere Automatikgetrieben, in einem Kraftfahrzeug werden Elektronikmodule verwendet, die in der Regel eine Getriebesteuereinheit mit einer elektronischen Schaltung ("transmission control unit", TCU), mindestens eine Steckverbindung zum Anschluss an einen Fahrzeugkabelbaum, elektrische Schnittstellen zum Ansteuern von Aktuatoren und wenigstens ein Sensorelement aufweisen.

Die Sensorelemente können insbesondere zur Bestimmung einer Drehzahl und/oder zur Bestimmung von Wegen bzw. Positionen in dem Getriebe ausgeführt sein. Beispielsweise können derartige Sensorelemente als Hallsensoren ausgeführt sein, etwa in Form einer integrierten Schaltung (bzw. eines "Integrated Circuits", IC) oder in Form einer anwendungsspezifischen integrierten Schaltung (bzw. "Application-Specific Integrated Circuit", ASIC).

In der Regel werden Anschlussdrähte bzw. elektrische Leitungen des Sensorelements an ein Zwischenstanzgitter geschweißt und diese Baugruppe kann an einem Kunststoffdom bzw. Domkörper montiert sowie anschließend mit einer Vergussmasse zu einem sogenannten Sensordom ausgeformt werden. Alternativ kann diese Baugruppe im Bereich des Sensorelements mit einem Duroplastmaterial ummoldet bzw. umspritzt werden, wobei in einem weiteren Prozessschritt beispielsweise mit Thermoplastmaterial der eigentliche Sensordom ausgeformt werden kann.

Die Sensordome können dann auf dem Elektronikmodul montiert und elektrisch mit Komponenten des Elektronikmoduls kontaktiert werden, insbesondere mit der elektronischen Schaltung der Getriebesteuereinheit.

Die EP 1 239 710 A2 offenbart eine elektronische Baugruppe, bei welcher ein Sensorelement durch Schweißen mit einer Leiterfolie elektrisch leitend verbunden ist.

Die DE 197 12 842 C1 beschreibt eine Vorrichtung der eingangs genannten Art. Die DE 10 2008 014 457 A1 offenbart eine elektrische verbindbare Schnittstelle zur elektrischen Verbindung einer Sensoreinheit mit einem Steuergerät.

### Offenbarung der Erfindung

### Vorteile der Erfindung

Die Aufgabe wird durch Anspruch 1 gelöst. Weitere Ausführungsbeispiele sind in den abhängigen Ansprüche definiert.

Ausführungsformen der vorliegenden Erfindung können in vorteilhafter Weise ermöglichen, ein robustes, zuverlässiges und kostengünstig produzierbares Elektronikmodul für ein Getriebesteuergerät eines Kraftfahrzeuges bereitzustellen.

Gemäß einem Aspekt der Erfindung wird ein Elektronikmodul für ein Getriebesteuergerät eines Kraftfahrzeugs vorgeschlagen, welches eine Getriebesteuereinheit mit einer elektronischen Schaltung, wenigstens ein Leiterplattenelement, z.B. ein HDI- und/oder PCB-Leiterplattenelement, und wenigstens einen Sensordom aufweist. Der Sensordom weist einen länglich ausgebildeten Domkörper auf, welcher mit einem ersten Ende auf dem Leiterplattenelement angeordnet ist und welcher von dem Leiterplattenelement abragt, wobei der Sensordom an einem dem ersten Ende gegenüberliegenden zweiten Ende ein elektronisches Sensorelement aufweist, und wobei das Sensorelement wenigstens zwei elektrische Leitungen aufweist, welche zumindest teilweise aus dem Domkörper ragen und welche jeweils mit einer zwischen einer Deckschicht und einer Basisschicht angeordneten Leiterbahn einer flexiblen Leiterfolie elektrisch leitfähig verbunden sind und/oder elektrisch kontaktiert sind. Die Leiterbahnen der Leiterfolie sind jeweils mit der elektronischen Schaltung der Getriebesteuereinheit elektrisch leitfähig verbunden, beispielsweise direkt oder indirekt über das Leiterplattenelement, ein Stanzgitter und/oder weitere Verbindungselemente. Das Elektronikmodul zeichnet sich erfindungsgemäß dadurch aus, dass das Elektronikmodul eine Fixiervorrichtung aufweist, mit welcher ein Teilbereich der Leiterfolie an einer Flanke des Domkörpers fixiert ist, wobei der Teilbereich der Leiterfolie zwischen dem Domkörper und der Fixiervorrichtung aufgenommen ist. Der Teilbereich der Leiterfolie kann beispielsweise ein Ende der Leiterfolie bezeichnen.

Die Fixiervorrichtung kann etwa eine Art Clip, Schelle und/oder Klemme bezeichnen, an welcher der Teilbereich der Leiterfolie zumindest teilweise befestigt sein kann. Die Fixiervorrichtung kann insbesondere fertigungstechnisch vorteilhaft sein, da zumindest der Teilbereich der flexiblen und/oder biegeschlaffen Leiterfolie durch die Fixiervorrichtung stabilisiert sein kann, so dass die Leiterfolie über die Fixiervorrichtung z.B. für eine Greifvorrichtung greifbar und/oder positionierbar sein kann und die Leiterfolie automatisiert an dem Domkörper befestigt und/oder gefügt werden kann. Ferner kann die Fixiervorrichtung die Leiterfolie an definierter Position an dem Domkörper halten, so dass eine z.B. gegen Vibration oder andere mechanische Einflüsse geschützte, stabile und robuste elektrische Verbindung zwischen den Leitungen des Sensorelements und den Leiterbahnen der Leiterfolie bereitgestellt sein kann. D.h. insbesondere kann die Fixiervorrichtung eine Robustheitssteigerung des Sensordoms und/oder des Elektronikmoduls gegen Schwingbelastung bewirken.

Ferner kann durch die direkte Kontaktierung der Leitungen des Sensorelements mit den Leiterbahnen der Leiterfolie etwa ein an die Leitungen des Sensorelements geschweißtes Zwischenstanzgitter entfallen. Insgesamt kann so eine Anzahl von Bauteilen sowie eine Anzahl elektrischer Schnittstellen bzw. eine Anzahl von Kontaktbereichen zwischen den Leitungen und den Leiterbahnen reduziert sein, was wiederum mit einer Kostenreduzierung einhergehen kann. Auch kann durch die Fixiervorrichtung eine Robustheitssteigerung des Elektronikmoduls gegen leitfähige und Kurzschlüsse induzierende Späne etwa aus einem das Elektronikmodul umspülenden Getriebefluid und/oder gegen leitende Ablagerungen (z.B. durch chemische und/oder elektrochemische Vorgänge) an den Schnittstellen bzw. Kontaktbereichen bewirkt werden. Mit anderen Worten können Kontaktbereiche zwischen den Leitungen des Sensorelements und den Leiterbahnen der Leiterfolie durch die Fixiervorrichtung vor Umgebungseinflüssen, wie etwa ein das Elektronikmodul umspülendes Getriebefluid, geschützt sein. Auch kann dadurch eine Umspritzung der Kontaktbereiche mit einer Vergussmasse entfallen.

Das Sensorelement kann z.B. ein ASIC, ein IC und/oder ein SMD-Baustein ("Surface Mounted Device") sein. Die elektrischen Leitungen können beispielsweise seitlich bzw. an einer Flanke des Domkörpers von dem Domkörper abragen, so dass durch die abragenden Leitungen je ein Kontaktbereich zum elektrischen Kontaktieren einer der Leitungen mit einer der Leiterbahnen der Leiterfolie bereitgestellt sein kann. Die flexible Leiterfolie kann eine Flexfolie, eine flexible Leiterplatte ("Flexible Printed Circuit", FPC) und/oder eine Flexleiterplatte bezeichnen, welche zwischen der Basisschicht und der Deckschicht angeordnete und/oder aufgenommene im Wesentlichen parallel zueinander verlaufende Leiterbahnen aufweisen kann.

Gemäß einer Ausführungsform der Erfindung ist der Teilbereich der Leiterfolie formschlüssig und/oder stoffschlüssig an der Fixiervorrichtung befestigt. Auch eine kraftschlüssige Verbindung ist denkbar. Beispielsweise kann die Fixiervorrichtung an den Teilbereich der Leiterfolie angespritzt und/oder angeklebt sein. Auch kann der Teilbereich etwa in eine an der Fixiervorrichtung ausgebildete Aufnahme aufgeschoben bzw. eingeschoben werden. Alternativ oder zusätzlich kann der Teilbereich auf die Fixiervorrichtung auflaminiert und/oder durch Heißstempelnieten angenietet sein.

Gemäß einer Ausführungsform der Erfindung ist die Fixiervorrichtung durch Formschluss und/oder Stoffschluss an der Flanke des Domkörpers fixiert. Beispielsweise kann die Fixiervorrichtung an den Domkörper geklebt sein. Erfindungsgemäß soll der Domkörper eine Abragung aufweisen und die Fixiervorrichtung eine kooperierend mit der Abragung ausgestaltete Ausnehmung aufweisen, in welche die Abragung des Domkörpers zumindest teilweise eingreift.

Die Fixiervorrichtung kann auch etwa an einem an dem Domkörper ausgebildeten Absatz abgestützt sein.

Erfindungsgemäß weist die Fixiervorrichtung wenigstens eine Abragung auf, und der Domkörper weist eine mit der Abragung der Fixiervorrichtung kooperierend ausgestaltete Ausnehmung auf, in welche die Abragung der Fixiervorrichtung zumindest teilweise eingreift, so dass die Fixiervorrichtung an dem Domkörper gehalten ist. Die Abragung kann etwa zapfenartig ausgestaltet sein und von einer Seite der Fixiervorrichtung abragen.

Gemäß einer Ausführungsform der Erfindung weist die Leiterfolie in dem am Domkörper fixierten Teilbereich eine Positionierausnehmung zum Positionieren des Teilbereichs der Leiterfolie an dem Domkörper auf, wobei die Abragung der Fixiervorrichtung durch die Positionierausnehmung in die Ausnehmung des Domkörpers ragt. Dies kann eine Robustheit gegen mechanische Belastung, etwa Schwingbelastung, der elektrischen Verbindung zwischen der Leiterfolie und den Leitungen des Sensorelements steigern, da der Teilbereich der Leiterfolie über die in die Positionierausnehmung eingreifende Abragung fixiert und/oder stabilisiert sein kann. Auch kann dies eine Fertigung vereinfachen, da die Leiterfolie ohne zusätzliche Positionierung und/oder Ausrichtung an einer vorbestimmten Position gehalten und etwa mit den Leitungen verbunden werden kann.

Gemäß einer Ausführungsform der Erfindung sind die wenigstens zwei elektrischen Leitungen des Sensorelements zumindest teilweise in einer Wandung, z.B. eine seitliche Wandung, des Domkörpers geführt und/oder eingebettet.

Gemäß einer Ausführungsform der Erfindung sind die elektrischen Leitungen des Sensorelements jeweils an einem Kontaktbereich mit einer Leiterbahn der Leiterfolie elektrisch leitfähig verbunden, wobei die Kontaktbereiche zwischen der Fixiervorrichtung und dem Domkörper angeordnet sind. So können die Kontaktbereiche zum einen durch die Basisschicht oder die Deckschicht der Leiterfolie und zum anderen durch die Fixiervorrichtung vor Umgebungseinflüssen, etwa ein das Elektronikmodul umspülendes Getriebefluid, geschützt sein. Ferner kann durch die an dem Domkörper fixierte Fixiervorrichtung sichergestellt sein, dass die Leiterfolie und insbesondere die Kontaktbereiche an die Flanke des Domkörpers gedrückt werden, so dass kein oder nur wenig Getriebefluid zwischen die Leiterfolie und den Domkörper gelangen kann. Derart können auch Kurzschlüsse und/oder Nebenschlüsse zwischen den elektrischen Leitungen des Sensorelements bzw. den Kontaktbereichen vermieden werden, welche etwa durch im Getriebefluid vorhandene elektrisch leifähige Partikel und/oder Späne (z.B. leitende Ablagerungen, Cu-Sulfide) und/oder durch Ionen enthaltende Öle induziert sein können.

Gemäß einer Ausführungsform der Erfindung sind die Kontaktbereiche in Längserstreckungsrichtung des Sensordoms versetzt zueinander angeordnet. Mit anderen Worten kann ein Kontaktbereich näher an Leiterplattenelement als der andere Kontaktbereich angeordnet sein. Die beiden Kontaktbereiche können beispielsweise wenigstens 0,3 mm und vorzugsweise wenigstens 0,6 mm auseinander liegen bzw. voneinander beabstandet sein. Derart kann sichergestellt sein, dass keine leitenden Partikel und/oder Späne die beiden Kontaktbereiche kurzschließen können.

Gemäß einer Ausführungsform der Erfindung weist die Fixiervorrichtung eine Ausnehmung auf, über welche die elektrischen Leitungen des Sensorelements jeweils mit einer Leiterbahn der Leiterfolie verschweißbar und/oder verlötbar sind. Über die Ausnehmung kann etwa ein Laser eingekoppelt werden und die Leitungen können mit den Leiterbahnen durch die Basischicht oder die Deckschicht der Leiterfolie hindurch verschweißt werden. Alternativ oder zusätzlich kann ein Schweißwerkzeug und/oder ein Lötwerkzeug über die Ausnehmung an die Kontaktbereiche gebracht werden. Insgesamt kann dies eine Fertigung vereinfachen.

Gemäß einer Ausführungsform der Erfindung sind die elektrischen Leitungen des Sensorelements jeweils an eine Leiterbahn der Leiterfolie gelötet und/oder geschweißt. Derart kann eine robuste und zuverlässige elektrische Verbindung zwischen den Leitungen und den Leiterbahnen hergestellt werden.

Gemäß einer Ausführungsform der Erfindung ist die Fixiervorrichtung zumindest teilweise aus Kunststoff gefertigt. Beispielsweise kann die Fixiervorrichtung aus Polyamid und/oder Polyamidimid gefertigt sein. Auch Thermoplastmaterial und/oder Duroplastmaterial ist denkbar. Derart kann auch ein thermischer Expansionskoeffizient ("Coefficient of Thermal Expansion", CTE) der Fixiervorrichtung mit einem CTE der Leiterfolie und/oder des Domkörpers abgestimmt sein, was mechanische Belastungen der elektrischen Verbindung reduzieren und damit eine Robustheit steigern kann.

Gemäß einer Ausführungsform der Erfindung ist ein dem Domkörper zugewandter und an dem Domkörper anliegender Bereich der Leiterfolie zumindest teilweise mit dem Domkörper verklebt. Derart kann sichergestellt sein, dass die Leiterfolie satt an dem Domkörper anliegen kann. Dies kann zum einen ein Verbinden der Kontaktpartner, d.h. der Leitungen und der Leiterbahnen, erleichtern und zum anderen können während eines Betriebes des Elektronikmoduls Kriechströme unterbunden werden, welche etwa durch Cu-Sulfid-Ablagerungen und/oder Ionen im Getriebefluid entstehen können.

Gemäß einer Ausführungsform der Erfindung ist der Bereich der Leiterfolie mit einem Haftklebstoff ("Pressure Sensitive Adhesive", PSA), einem epoxidharzbasierten Klebstoff und/oder einem acrylbasierten Klebstoff mit dem Domkörper verklebt. Derart kann der Klebstoff etwa durch Druck und/oder Wärme schnell vorvernetzt und/oder ausgehärtet werden und eine Produktion des Elektronikmoduls kann vereinfacht bzw. beschleunigt werden.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
Fig. 1 zeigt ein Elektronikmodul gemäß einer Ausführungsform der Erfindung.
Fig. 2 zeigt einen Längsschnitt durch einen Sensordom für ein Elektronikmodul gemäß einer Ausführungsform der Erfindung.
Fig. 3 zeigt eine Seitenansicht eines Sensordoms für ein Elektronikmodul gemäß einer Ausführungsform der Erfindung.

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

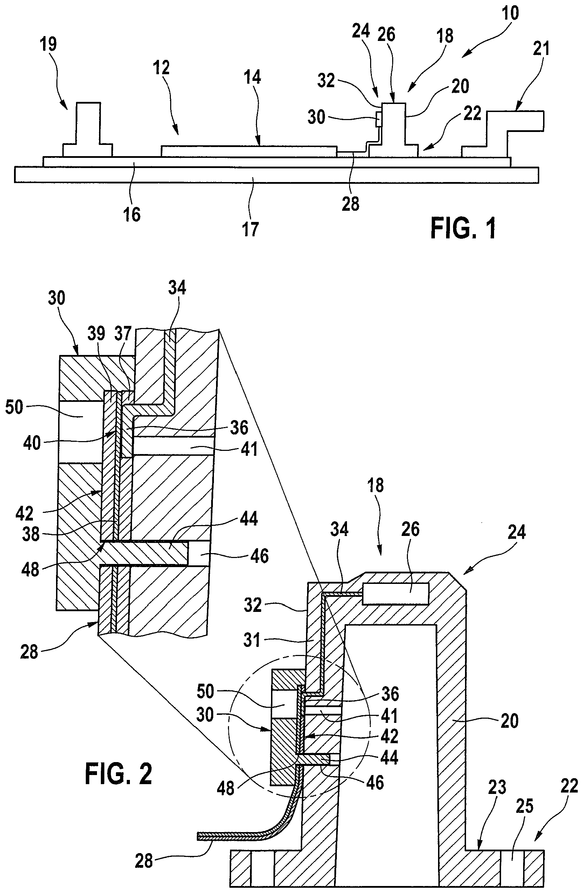

Fig. 1 zeigt ein Elektronikmodul 10 für ein Getriebesteuergerät eines Kraftfahrzeugs gemäß einer Ausführungsform der Erfindung.

Das Elektronikmodul 10 weist eine Getriebesteuereinheit ("Transmission Control Unit", TCU) 12 mit einer elektronischen Schaltung 14 auf, welche auf einem Leiterplattenelement 16 angeordnet und befestigt ist. Das Leiterplattenelement 16 kann etwa ein HDI ("High-Density Interconnect") und/oder ein PCB ("Printed Circuit Board") Leiterplattenelement sein. Das Elektronikmodul 10 kann auch eine Mehrzahl von Leiterplattenelementen 16 aufweisen, beispielsweise ein Leiterplattenelement 16, auf welchem die Getriebesteuereinheit 12 angeordnet ist und weiteres Leiterplattenelement, auf welchem weitere Komponenten des Elektronikmoduls 10 angeordnet sind und welches z.B. das Leiterplattenelement 16 entlang eines Umfangs ringförmig umschließt.

Das Leiterplattenelement 16 ist auf einer Trägerplatte 17 angeordnet und/oder befestigt. Die Trägerplatte 17 kann insbesondere zum Abführen von Wärme aus Metall, z.B. Aluminium, und/oder einem Keramikmaterial gefertigt sein. Die Trägerplatte 17 kann z.B. auf einer Getriebesteuerplatte befestigt sein oder die Getriebesteuerplatte kann gleichzeitig die Funktion der Trägerplatte haben.

Weiter weist das Elektronikmodul 10 einen Sensordom 18 auf, welcher einen länglichen Domkörper 20 aufweist und mit einem ersten Ende 22 auf dem Leiterplattenelement 16 angeordnet und/oder befestigt ist. Der Sensordom 18 ragt dabei im Wesentlichen parallel zu einem Flächennormalenvektor des Leiterplattenelements 16 von dem Leiterplattenelement 16 ab. Der Sensordom 18 weist an einem dem ersten Ende 22 gegenüberliegenden zweiten Ende 24 ein elektronisches Sensorelement 26 (siehe Fig. 2) auf, beispielsweise einen ASIC, einen IC, einen SMD-Baustein und/oder ein anderes Sensorelement.

Das Sensorelement 26 ist elektrisch leitfähig mit einer Leiterfolie 28 verbunden, wobei die Leiterfolie 28 mit einer Fixiervorrichtung 30 an einer Flanke 32 des Domkörpers 20 fixiert ist, wie im Detail in nachfolgenden Figuren beschrieben. Die Leiterfolie 28 ist ferner mit der Getriebesteuereinheit 12 und/oder der elektronischen Schaltung 14 elektrisch leitfähig verbunden.

Das Elektronikmodul 10 weist ferner einen weiteren Sensordom 19 auf, welcher entweder ähnlich dem Sensordom 18 ausgestaltet und mit einer Leiterfolie elektrisch kontaktiert sein kann oder anders elektrisch kontaktiert sein kann.

Ferner weist das Elektronikmodul 10 einen Steckverbinder 21 auf, welcher beispielsweise mit elektrischen Leitungen eines Kraftfahrzeugs, z.B. einem Kabelbaum, verbunden werden kann.

Fig. 2 zeigt einen Längsschnitt durch einen Sensordom 18 für ein Elektronikmodul 10 gemäß einer Ausführungsform der Erfindung. Der Sensordom 18 der Fig. 2 kann dieselben Elemente und Merkmale aufweisen wie der Sensordom 18 der Fig. 1.

Der Sensordom 18 weist an dem ersten Ende 22 einen Flansch 23 mit Ausnehmungen 25 auf, welche dazu ausgeführt sind, den Sensordom 18 etwa durch Anschrauben, Annieten und/oder Warmnieten an dem Elektronikmodul 10 bzw. dem Leiterplattenelement 16, einem Getriebeteil und/oder einem Getriebesteuermodul zu befestigen.

Wie in Fig. 2 deutlich erkennbar ist das Sensorelement 26 in den Sensordom 18 am zweiten Ende 24 des Sensordoms 18 eingebettet, integriert und/oder eingespritzt, wobei ein Material des Sensordoms 18 das Sensorelement 26 im Wesentlichen umschließt. Das Sensorelement 26 weist wenigstens zwei elektrische Leitungen 34 auf, welche zumindest teilweise in einer Wandung, insbesondere in einer seitlichen Wandung 31, des Sensordoms 18 bzw. des Domkörpers 20 geführt und/oder eingebettet sind. Das Sensorelement 26 kann auch mehr als zwei elektrische Leitungen 34 aufweisen. Die elektrischen Leitungen 34 des Sensorelements 26 sind dabei derart in dem Domkörper 20 geführt, dass ein Ende 35 jeder elektrischen Leitung 34 aus dem Domkörper 20 ragt und zum elektrischen Kontaktieren der Leitungen 34 von außen zugänglich ist.

Die Enden 35 der Leitungen 34 sind jeweils an einem Kontaktbereich 40 mit einer Leiterbahn 38 der Leiterfolie 28 elektrisch leitfähig verbunden, beispielsweise verlötet, verschweißt und/oder mittels Leitkleber verklebt. Jede der Leitungen 34 ist mit einer separaten Leiterbahn 38 verbunden, wobei die Leiterbahnen 38 zwischen einer Basisschicht 36 und einer Deckschicht 39 der Leiterfolie 28 aufgenommen und/oder angeordnet sind. Zum Kontaktieren der Leitungen 34 mit den Leiterbahnen 38 kann etwa die Basisschicht 36 um die Kontaktbereiche 40 herum abgetragen bzw. eine Ausnehmung in die Basisschicht 37 eingebracht werden, sodass die Leiterbahnen 38 freiliegen und zugänglich sind. Ferner können die Leitungen 34 an den Kontaktbereichen 40 bzw. an den Enden 35 jeweils einen Lötbuckel und/oder einen Schweißbuckel aufweisen, welcher etwa eine einer Dicke der Basisschicht 37 entsprechende Dicke von rund 0,05 bis 0,2 mm aufweisen kann, so dass eine zuverlässige elektrische Verbindung hergestellt werden kann.

Weiter ist in Fig. 2 die im Wesentlichen aus Kunststoff ausgebildete Fixiervorrichtung 30 deutlich erkennbar. Ein Teilbereich 42, z.B. ein Ende, der Leiterfolie 28 ist an der Fixiervorrichtung 30 befestigt. Beispielsweise kann die Fixiervorrichtung 30 an den Teilbereich 42 angespritzt und/oder angeklebt sein. Auch kann der Teilbereich 42 in eine Aufnahme der Fixiervorrichtung aufgeschoben sein und formschlüssig an der Fixiervorrichtung 30 gehalten sein. Auch kann der Teilbereich 42 auf die Fixiervorrichtung 30 laminiert und/oder durch Heißstempelnieten angenietet sein.

Die Fixiervorrichtung 30 weist eine zapfenartig ausgestaltet Abragung 44 auf, welche in eine kooperierend ausgestaltete Ausnehmung 46 des Domkörpers 20 zumindest teilweise eingreift, so dass die Fixiervorrichtung 30 und der Teilbereich 42 der Leiterfolie 28 an der Flanke 32 des Domkörpers 20 gehalten sind. Alternativ oder zusätzlich kann die Fixiervorrichtung 30 etwa mit dem Domkörper 20 verklebt sein. Die Abragung 44 ragt dabei durch eine in die Leiterfolie 28 eingebrachte Positionierausnehmung 48, so dass die Leiterfolie 28 und insbesondere der Teilbereich 42 an einer vorbestimmten Position fixiert ist.

Der Teilbereich 42 der Leiterfolie 28 ist zwischen der Flanke 32 des Domkörpers 20 und der Fixiervorrichtung 30 angeordnet und liegt vorzugsweise vollflächig an der Flanke 32 des Domkörpers 20 an. Der Teilbereich 42 kann von der Fixiervorrichtung 30 an die Flanke 32 gedrückt werden, so dass kein Getriebefluid zwischen den Domkörper 20 und den Teilbereich 42 eindringen kann, etwa um Kurzschlüsse durch im Getriebefluid enthaltene Späne und/oder leitende Partikel zu vermeiden. Um ein vollflächiges Anliegen und/oder ein Andrücken zu gewährleisten, kann etwa eine der Flanke 32 des Domkörpers 20 gegenüberliegende Fläche der Fixiervorrichtung 30 kooperierend mit der Flanke 32 ausgestaltet sein. Wenn beispielsweise der Domkörper im Wesentlichen zylindrisch ausgestaltet ist, kann die Fläche der Fixiervorrichtung 30 abgerundet ausgestaltet sein. Ist dagegen der Domkörper quaderförmig, kann die Fläche eben bzw. planar ausgebildet sein.

Zum Herstellen der elektrischen Verbindungen zwischen den Leiterbahnen 38 der Leiterfolie 28 und den Leitungen 34 des Sensorelements 26 weist die Fixiervorrichtung 30 ferner eine Ausnehmung 50 auf, über welche die Leiterbanen 38 mit den Leitungen 34 verlötet und/oder verschweißt werden können, wie nachfolgend näher erläutert.

Ein Herstellungsprozess des Elektronikmoduls 10 und/oder des Sensordoms 18 kann wie nachfolgend beschrieben von Statten gehen. Das Sensorelement 26 wird in einem Spritzwerkzeug, vorzugsweise einem Duroplast-Spritzwerkzeug, positioniert und mit Duroplastmaterial und/oder Thermoplastmaterial umspritzt. Alternativ kann Transfermolden und/oder ein anderes Duroplastverfahren Verwendung finden. Der Sensordom 18 wird mit Sensorelement 26 z.B. aus Duroplast ausgeformt, z.B. gespritzt oder gemoldet. Die Leitungen 34 des Sensorelements 26 werden im Werkzeug so positioniert, dass sie nahezu bündig im Werkzeug anliegen und somit am fertigen Sensordom 18 sichtbar und zum Verbinden mit den Leiterbahnen 38 der Leiterfolie 28 zugänglich sind. Gegebenenfalls kann ein Bereich der Flanke 32 des Domkörpers 20 bzw. die Enden 36 der Leitungen 34 mechanisch freigelegt werden, etwa durch Schleifen und/oder Abtragen von Material des Domkörpers 20. Das Duroplastmaterial des Sensordoms 18 und die Leitungen 34 können auf Haftung optimiert sein, um ein Eindringen von Getriebefluid bis zum Sensorelement 26 zu verhindern. Hierzu können die Leitungen 34 partiell beschichtet sein. Wenn etwa das Duroplastmaterial auf Haftung an Kupfer optimiert ist, können die Leitungen 34 in einem Bereich nahe des Sensorelements 26 bzw. nahe einem ASIC-Gehäuse aus unbeschichtetem Kupfer bestehen und die Enden 36 der Leitungen 34 können verzinnt sein. Wenn die Haftung auf Zinn optimiert ist, können die gesamten Leitungen 34 verzinnt sein.

Die Leitungen 34 bzw. die Enden 36 können so gebogen sein, dass ein Löt- oder Schweißbuckel gebildet wird, der aus der Flanke 32 herausragt (z. B. 0,05- 0,2 mm), weil diese Strecke beim Anschließen einer einseitig geöffneten Leiterfolie 28 zu überbrücken ist. Mit anderen Worten kann eine erhabene Anschlussstelle der Leitungen 34 aus dem Domkörper 20 herausragen, welche etwa genau in eine Ausnehmung der Basisschicht 37 der Leiterfolie 28 passen kann. Ein Schieber im Spritzwerkzeug kann dazu die Enden 36 über eine Ausnehmung 41 in der Flanke 32 des Domkörpers 20 positioniert nach außen gegen einen weiteren Werkzeugschieber drücken, der eine Anschlussoberfläche der Enden 36 frei von Kunststoff halten kann. Die einseitig aufgelegte Leiterfolie 28 kann an der Fixiervorrichtung 30 angebracht werden und etwa mit einem Greifer automatisiert an der Flanke 32 des Domkörpers befestigt werden.

Über die Ausnehmung 50 der Fixiervorrichtung 30 kann dann die eigentliche elektrische Verbindung an den Kontaktbereichen 40 zwischen den Leiterbahnen 38 und den Leitungen 34 durch Löten und/oder Schweißen hergestellt werden. Sind die Kontaktpartner, d.h. die Enden 36 der Leitungen 34 und/oder die Leiterbahnen 38, ausreichend vorverzinnt, kann z.B. durch reinen Wärmeeintrag gelötet werden, beispielsweise mittels Bügellöten, Laserlöten und/oder Lichtlöten. Es kann auch mittels Laser geschweißt werden, wobei auch Kupfer auf Kupfer geschweißt werden kann. Beim Schweißen kann ein Andrücken der Leiterfolie 28 nötig sein. Dies kann z. B. durch Ankleben der Leiterfolie 28 an die Flanke 32 erfolgen. Auch beim Laser- oder Lichtlöten durch die geschlossene Deckschicht 39 der Leiterfolie 28 kann ein Andrücken nötig sein. Beim Bügellöten kann das Werkzeug die Kontaktpartner zusammendrücken und Wärme kann über die Ausnehmung 50 durch die Deckschicht 39 eingekoppelt werden. Bei einer Bügellötanlage, die die Leitungen 34 bzw. Leiterbahnen 38, welche aus Kupfer sein können, direkt berührt, kann sich ein umlaufendes Trennband aus Kapton zwischen dem Bugellötwerkzeug und der zu lötenden Leitung 34 bzw. Leiterbahn 38 befinden, um ein Anhaften zu vermeiden. Auch hier ist seitliches Niederdrücken und/oder Ankleben der Leiterfolie 28 vorteilhaft, damit die Lötstelle beim Wegfahren des Lötwerkzeugs weiterhin zusammengedrückt werden kann.

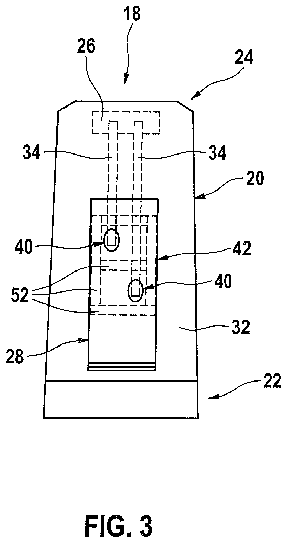

Fig. 3 zeigt eine Seitenansicht eines Sensordoms 18 für ein Elektronikmodul 10 gemäß einer Ausführungsform der Erfindung. Der Sensordom 18 der Fig. 3 kann dieselben Elemente und Merkmale wie die Sensordome 18 der Fig. 1 und 2 aufweisen. Der Übersichtlichkeit halber ist der Sensordom 18 der Fig. 3 ohne Fixiervorrichtung 30 gezeigt.

Der Teilbereich 42 der Leiterfolie 28 ist mittels einer Verklebung 52 an der Flanke 32 des Domkörpers 20 befestigt. Die Verklebung 52 kann dabei einen Bereich der Leiterfolie 28 bezeichnen, welcher mit dem Domkörper 20 verklebt ist. Beispielsweise kann die Verklebung bzw. der Bereich 52 auf einem Randbereich der Basisschicht 37 der Leiterfolie 28 und/oder zwischen den Kontaktstellen 40 angeordnet sein. Die Verklebung 52 kann mit einem Haftklebstoff (PSA), einem epxidharzbasierten Klebstoff und/oder einem acrylbasiertem Klebstoff hergestellt sein, wobei der Klebstoff etwa mit einem heißen Anpressstempel aktiviert werden kann. Auch kann ein 1K-heißhärtender Epoxikleber und/oder ein Polyacrylatkleber mit UV-Licht-Aktivierung und sofortiger Aushärtung verwendet werden.

In Fig. 3 sind weiter die in Längserstreckungsrichtung des Domkörpers 20 versetzt zueinander angeordneten Kontaktbereiche 40 gut erkennbar, wodurch Kurz- und/oder Nebenschlüsse durch Fremdstoffe, Ablagerungen oder leitende Öle im Getriebefluid vermieden werden können, wie obenstehend detailliert erläutert.

## Patentansprüche

1. Elektronikmodul (10) für ein Getriebesteuergerät eines Kraftfahrzeugs, aufweisend:
eine Getriebesteuereinheit (12) mit einer elektronischen Schaltung (14);
wenigstens ein Leiterplattenelement (16); und
wenigstens einen Sensordom (18),
wobei der Sensordom einen länglich ausgebildeten Domkörper (20) aufweist, welcher mit einem ersten Ende (22) auf dem Leiterplattenelement angeordnet ist und welcher von dem Leiterplattenelement abragt,
wobei der Sensordom (18) an einem dem ersten Ende (22) gegenüberliegenden zweiten Ende (24) ein elektronisches Sensorelement (26) aufweist,
wobei das Sensorelement wenigstens zwei elektrische Leitungen (34) aufweist, welche zumindest teilweise aus dem Domkörper ragen und welche jeweils mit einer zwischen einer Deckschicht (39) und einer Basisschicht (37) angeordneten Leiterbahn (38) einer flexiblen Leiterfolie (28) elektrisch leitfähig verbunden sind, und
wobei die Leiterbahnen der Leiterfolie jeweils mit der elektronischen Schaltung (14) der Getriebesteuereinheit elektrisch leitfähig verbunden sind,
**dadurch gekennzeichnet, dass**
das Elektronikmodul eine Fixiervorrichtung (30) aufweist, mit welcher ein Teilbereich (42) der Leiterfolie (28) an einer Flanke (32) des Domkörpers (20) fixiert ist, wobei die Fixiervorrichtung (30) wenigstens eine Abragung (44) aufweist, und wobei der Domkörper (20) eine mit der Abragung (44) der Fixiervorrichtung kooperierend ausgestaltete Ausnehmung (46) aufweist, in welche die Abragung (44) der Fixiervorrichtung (30) zumindest teilweise eingreift,
wobei der Teilbereich (42) der Leiterfolie zwischen einer Flanke (32) des Domkörpers (20) und der Fixiervorrichtung (30) aufgenommen ist, so dass die Fixiervorrichtung (30) an dem Domkörper (20) gehalten ist.

2. Elektronikmodul (10) nach Anspruch 1, wobei der Teilbereich (42) der Leiterfolie formschlüssig und/oder stoffschlüssig an der Fixiervorrichtung (30) befestigt ist.

3. Elektronikmodul (10) nach Anspruch 1 oder 2, wobei die Fixiervorrichtung (30) durch Formschluss und/oder Stoffschluss an der Flanke (32) des Domkörpers (20) fixiert ist.

4. Elektronikmodul (10) nach einem der voranstehenden Ansprüche, wobei die Abragung (44) etwa zapfenförmig ausgestaltet ist und von einer Seite der Fixiervorrichtung (30) abragt.

5. Elektronikmodul (10) nach Anspruch 1,
wobei die Leiterfolie (28) in dem am Domkörper fixierten Teilbereich (42) eine Positionierausnehmung (48) zum Positionieren des Teilbereichs (42) der Leiterfolie an dem Domkörper (20) aufweist, und
wobei die Abragung (44) der Fixiervorrichtung durch die Positionierausnehmung (48) in die Ausnehmung (46) des Domkörpers ragt.

6. Elektronikmodul (10) nach einem der voranstehenden Ansprüche,
wobei die wenigstens zwei elektrischen Leitungen (34) des Sensorelements (26) zumindest teilweise in einer Wandung (31) des Domkörpers (20) geführt sind, und/oder wobei die elektrischen Leitungen (34) jeweils an einem Kontaktbereich (40) mit einer Leiterbahn (38) der Leiterfolie elektrisch leitfähig verbunden sind,
wobei die Kontaktbereiche (40) zwischen der Fixiervorrichtung (30) und dem Domkörper (20) angeordnet sind.

7. Elektronikmodul (10) nach Anspruch 6, wobei die Kontaktbereiche (40) in Längserstreckungsrichtung des Sensordoms (18) versetzt zueinander angeordnet sind.

8. Elektronikmodul (10) nach einem der voranstehenden Ansprüche,
wobei die Fixiervorrichtung (30) eine Ausnehmung (50) aufweist, über welche die elektrischen Leitungen (34) des Sensorelements (26) jeweils mit einer Leiterbahn (38) der Leiterfolie verschweißbar und/oder verlötbar sind; und/oder
wobei die elektrischen Leitungen (34) des Sensorelements jeweils an eine Leiterbahn (38) der Leiterfolie (28) gelötet und/oder geschweißt sind.

9. Elektronikmodul (10) nach einem der voranstehenden Ansprüche, wobei die Fixiervorrichtung (30) zumindest teilweise aus Kunststoff gefertigt ist.

10. Elektronikmodul (10) nach einem der voranstehenden Ansprüche, wobei ein dem Domkörper (20) zugewandter und an dem Domkörper anliegender Bereich (52) der Leiterfolie zumindest teilweise mit dem Domkörper verklebt ist.

11. Elektronikmodul (10) nach Anspruch 10, wobei der Bereich (52) der Leiterfolie mit einem Haftklebstoff, einem epoxidharzbasierten Klebstoff und/oder einem acrylbasierten Klebstoff mit dem Domkörper verklebt ist.

## Claims

1. Electronics module (10) for a transmission controller of a motor vehicle, having:
a transmission control unit (12) with an electronic circuit (14);
at least one printed circuit board element (16); and
at least one sensor dome (18),
wherein the sensor dome has a dome body (20) of elongate design which is arranged with a first end (22) on the printed circuit board element and which protrudes from the printed circuit board element,
wherein the sensor dome (18) has an electronic sensor element (26) on a second end (24) opposite the first end (22),
wherein the sensor element has at least two electrical lines (34) which at least partially project out of the dome body and which are each electrically conductively connected to a conductor track (38), arranged between a covering layer (39) and a base layer (37), of a flexible conductor foil (28), and
wherein the conductor tracks of the conductor foil are each electrically conductively connected to the electronic circuit (14) of the transmission control unit, **characterized in that**
the electronics module has a fixing device (30) by way of which a partial region (42) of the conductor foil (28) is fixed to a flank (32) of the dome body (20), wherein the fixing device (30) has at least one protrusion (44), and wherein the dome body (20) has a cutout (46) which is configured to cooperate with the protrusion (44) of the fixing device and into which the protrusion (44) of the fixing device (30) at least partially engages,
wherein the partial region (42) of the conductor foil is received between a flank (32) of the dome body (20) and the fixing device (30), so that the fixing device (30) is held on the dome body (20).

2. Electronics module (10) according to Claim 1, wherein the partial region (42) of the conductor foil is fastened to the fixing device (30) in an interlocking and/or materially bonded manner.

3. Electronics module (10) according to Claim 1 or 2, wherein the fixing device (30) is fixed to the flank (32) of the dome body (20) by means of an interlocking connection and/or a materially bonded connection.

4. Electronics module (10) according to one of the preceding claims, wherein the protrusion (44) is of approximately peg-like configuration and protrudes from one side of the fixing device (30).

5. Electronics module (10) according to Claim 1, wherein the conductor foil (28) has, in the partial region (42) fixed to the dome body, a positioning cutout (48) for positioning the partial region (42) of the conductor foil on the dome body (20), and wherein the protrusion (44) of the fixing device projects through the positioning cutout (48) into the cutout (46) of the dome body.

6. Electronics module (10) according to one of the preceding claims,
wherein the at least two electrical lines (34) of the sensor element (26) are at least partially guided in a wall (31) of the dome body (20), and/or
wherein the electrical lines (34) are each electrically conductively connected to a conductor track (38) of the conductor foil at a contact region (40),
wherein the contact regions (40) are arranged between the fixing device (30) and the dome body (20).

7. Electronics module (10) according to Claim 6, wherein the contact regions (40) are arranged offset in relation to one another in the direction of longitudinal extent of the sensor dome (18).

8. Electronics module (10) according to one of the preceding claims,
wherein the fixing device (30) has a cutout (50) via which the electrical lines (34) of the sensor element (26) can each be welded and/or soldered to a conductor track (38) of the conductor foil; and/or
wherein the electrical lines (34) of the sensor element are each soldered and/or welded to a conductor track (38) of the conductor foil (28).

9. Electronics module (10) according to one of the preceding claims, wherein the fixing device (30) is at least partially manufactured from plastic.

10. Electronics module (10) according to one of the preceding claims, wherein a region (52), which faces the dome body (20) and adjoins the dome body, of the conductor foil is at least partially adhesively bonded to the dome body.

11. Electronics module (10) according to Claim 10, wherein the region (52) of the conductor foil is adhesively bonded to the dome body using a pressure-sensitive adhesive, an epoxy resin-based adhesive and/or an acrylic-based adhesive.

## Revendications

1. Module électronique (10) destiné à une unité de commande de transmission d'un véhicule automobile, ledit module comprenant :
une unité de commande de transmission (12) pourvue d'un circuit électronique (14) ;
au moins un élément de carte de circuit imprimé (16) ; et
au moins un dôme de capteur (18),
le dôme de capteur comportant un corps de dôme allongé (20) qui est disposé avec une première extrémité (22) sur l'élément de carte de circuit imprimé et qui fait saillie de l'élément de carte de circuit imprimé,
le dôme de capteur (18) comportant un élément de capteur électronique (26) à une seconde extrémité (24) opposée à la première extrémité (22),
l'élément de capteur comportant au moins deux lignes électriques (34) qui font saillie au moins partiellement du corps de dôme et qui sont chacune reliées électriquement à une piste conductrice (38) d'un film conducteur flexible (28) disposée entre une couche de revêtement (39) et une couche de base (37), et
les pistes conductrices du film conducteur étant chacune reliées électriquement au circuit électronique (14) de l'unité de commande de transmission, **caractérisé en ce que**
le module électronique comporte un dispositif de fixation (30) permettant de fixer une partie (42) du film conducteur (28) à un flanc (32) du corps de dôme (20), le dispositif de fixation (30) comportant au moins une saillie (44), et le corps de dôme (20) comportant un évidement (46) qui est destiné à coopérer avec la saillie (44) du dispositif de fixation et dans lequel s'engage la saillie (44) du dispositif de fixation (30),
la partie (42) du film conducteur étant reçue entre un flanc (32) du corps de dôme (20) et le dispositif de fixation (30) de façon à maintenir le dispositif de fixation (30) sur le corps de dôme (20).

2. Module électronique (10) selon la revendication 1, la partie (42) du film conducteur étant fixée au dispositif de fixation (30) par une liaison par complémentarité de formes et/ou par une liaison de matière.

3. Module électronique (10) selon la revendication 1 ou 2,
le dispositif de fixation (30) étant fixé au flanc (32) du corps de dôme (20) par une liaison par complémentarité de formes et/ou par une liaison de matière.

4. Module électronique (10) selon l'une des revendications précédentes,
la saillie (44) étant conçue à peu près en forme de téton et faisant saillie d'un côté du dispositif de fixation (30).

5. Module électronique (10) selon la revendication 1, le film conducteur (28) comportant un évidement de positionnement (48) destiné à positionner la partie (42) du film conducteur sur le corps de dôme (20) dans la partie (42) fixée au corps de dôme, et
la saillie (44) du dispositif de fixation faisant saillie dans l'évidement (46) du corps de dôme à travers l'évidement de positionnement (48).

6. Module électronique (10) selon l'une des revendications précédentes,
les au moins deux lignes électriques (34) de l'élément de capteur (26) étant au moins partiellement guidées dans une paroi (31) du corps de dôme (20), et/ou les lignes électriques (34) étant chacune reliées électriquement à une piste conductrice (38) du film conducteur au niveau d'une zone de contact (40),
les zones de contact (40) étant disposées entre le dispositif de fixation (30) et le corps de dôme (20).

7. Module électronique (10) selon la revendication 6, les zones de contact (40) étant disposées en étant décalées les unes des autres dans la direction d'extension longitudinale du dôme de capteur (18).

8. Module électronique (10) selon l'une des revendications précédentes,
le dispositif de fixation (30) comportant un évidement (50) permettant de souder et/ou de braser les lignes électriques (34) de l'élément de capteur (26) à une piste conductrice (38) du film conducteur ; et/ou les lignes électriques (34) de l'élément de capteur étant chacune brasées et/ou soudées à une piste conductrice (38) du film conducteur (28).

9. Module électronique (10) selon l'une des revendications précédentes, le dispositif de fixation (30) étant au moins partiellement réalisé en matière synthétique.

10. Module électronique (10) selon l'une des revendications précédentes,
une région (52) du film conducteur, qui est dirigée vers le corps de dôme (20) et vient en appui sur le corps de dôme, étant au moins partiellement collée au corps de dôme.

11. Module électronique (10) selon la revendication 10,
la région (52) du film conducteur étant collée au corps de dôme à l'aide d'un adhésif sensible à la pression, d'un adhésif à base de résine époxy et/ou d'un adhésif acrylique.
